# FASCICULE DE BREVET EUROPEEN

(11) **EP 3 680 936 B1**
(45) Date de publication et mention de la délivrance du brevet: **04.08.2021**
(21) Numéro de dépôt: 20151445.2
(22) Date de dépôt: 13.01.2020
(51) Int. Cl.: H01L 27/146

(54) **CAPTEUR D'IMAGES À ÉCLAIREMENT PAR LA FACE ARRIÈRE**
VON HINTEN BELEUCHTETER BILDSENSOR
BACK-ILLUMINATED IMAGE SENSOR

(30) Priorité: 14.01.2019 FR 1900323
(43) Date de publication de la demande: 15.07.2020
(73) Titulaire: Commissariat à l'Energie Atomique et aux Energies Alternatives, 75015 Paris (FR); STMicroelectronics (Crolles 2) SAS, 38920 Crolles (FR)
(72) Inventeur: GAY, Laurent, 38660 LUMBIN (FR); LALANNE, Frederic, 38190 BERNIN (FR); HENRION, Yann, 38600 FONTAINE (FR); GUYADER, Francois, 38330 MONTBONNOT (FR); FONTENEAU, Pascal, 38570 THEYS (FR); SEIGNARD, Aurélien, 38100 GRENOBLE (FR)
(74) Mandataire: Cabinet Beaumont

(56) Documents cités:
- CN-A- 107 507 842
- FR-A1- 2 974 237
- US-A1- 2018 166 475

## Description

### Domaine technique

La présente demande concerne un capteur d'images à éclairement par la face arrière et un procédé de fabrication d'un tel capteur.

### Technique antérieure

Un capteur d'images à éclairement par la face arrière comprend classiquement une couche semiconductrice dont une face, appelée face avant, est revêtue d'un empilement de couches isolantes et conductrices formant une structure d'interconnexion, et dont la face opposée à la face avant, appelée face arrière, est destinée à recevoir un éclairement provenant d'une scène dont on souhaite acquérir une image. Le capteur comprend une pluralité de pixels, par exemple disposés en matrice, formés dans et sur la couche semiconductrice. Chaque pixel comprend en particulier une zone de photodétection formée dans la couche semiconductrice, et un ou plusieurs transistors de contrôle formés dans et sur la couche semiconductrice, du côté de la face avant de la couche semiconductrice. Les pixels sont connectés entre eux par l'intermédiaire de la structure d'interconnexion.

Le document FR 2974237 décrit un capteur d'images à éclairement par la face arrière comprenant des murs d'isolation.

Il serait souhaitable d'améliorer au moins en partie certains aspects des capteurs d'images à éclairement par la face arrière connus.

### Résumé de l'invention

Ainsi, un mode de réalisation prévoit un procédé de fabrication d'un capteur d'images, comportant les étapes successives suivantes :
a) réaliser une structure comportant une couche semiconductrice ayant une face avant et une face arrière, et un mur d'isolation capacitif s'étendant verticalement de la face avant à la face arrière de la couche semiconductrice, le mur d'isolation capacitif comprenant des première et deuxième parois isolantes séparées par une région en un matériau conducteur ou semiconducteur ;
b) graver, depuis la face arrière de ladite structure, une partie de l'épaisseur de la couche semiconductrice et de la région en un matériau conducteur ou semiconducteur de façon sélective par rapport aux parois isolantes, de façon que, à l'issue de la gravure, chacune des première et deuxième parois isolantes présente une portion en saillie de la face arrière de la couche semiconductrice et de la face arrière de la région en un matériau conducteur ou semiconducteur ;
c) déposer une couche diélectrique de passivation sur la face arrière de la structure ; et
d) retirer localement la couche diélectrique de passivation en vis-à-vis de la face arrière des portions en saillie des première et deuxième parois isolantes.

Selon un mode de réalisation, l'étape d) comprend une étape de dépôt d'une couche sacrificielle sur la face arrière de la couche diélectrique de passivation, suivie d'une étape d'amincissement de la couche sacrificielle par sa face arrière jusqu'à atteindre la face arrière des portions en saillie des première et deuxième parois isolantes.

Selon un mode de réalisation, l'étape d) comprend en outre, après l'étape d'amincissement, une étape de retrait des portions restantes de la couche sacrificielle.

Selon un mode de réalisation, la couche sacrificielle est en nitrure de silicium.

Selon un mode de réalisation, le procédé comprend en outre, après l'étape d), une étape de dépôt d'une couche antireflet sur la face arrière de la couche diélectrique de passivation et sur la face arrière des portions en saillie des première et deuxième parois isolantes.

Selon un mode de réalisation, le procédé comprend, avant l'étape d), une étape de dépôt d'une couche antireflet sur la face arrière de la couche diélectrique de passivation, et, à l'étape d), la couche antireflet est retirée localement en vis-à-vis de la face arrière des portions en saillie des première et deuxième parois isolantes.

Selon un mode de réalisation, la couche antireflet comprend de l'oxyde de tantale.

Selon un mode de réalisation, la couche diélectrique de passivation comprend un matériau diélectrique de constante diélectrique supérieure à celle de l'oxyde de silicium, par exemple de l'oxyde d'aluminium ou de l'oxyde d'hafnium.

Selon un mode de réalisation, le procédé comprend, après l'étape b) et avant l'étape c), une étape d'oxydation de la face arrière de la couche semiconductrice.

Selon un mode de réalisation, la couche semiconductrice est en silicium monocristallin, la région en un matériau conducteur ou semiconducteur est en silicium polycristallin ou amorphe, et les première et deuxième parois isolantes sont en oxyde de silicium.

Selon un mode de réalisation, le mur d'isolation capacitif comprend une troisième paroi isolante séparant la région en un matériau conducteur ou semiconducteur en deux parois distinctes.

Selon un mode de réalisation, la structure réalisée à l'étape a) comprend en outre une structure d'interconnexion revêtant la face avant de la couche semiconductrice.

Un autre mode de réalisation prévoit un capteur d'images comportant une couche semiconductrice ayant une face avant et une face arrière, et un mur d'isolation capacitif s'étendant verticalement de la face avant à la face arrière de la couche semiconductrice, le mur d'isolation capacitif comprenant des première et deuxième parois isolantes séparées par une région en un matériau conducteur ou semiconducteur, dans lequel chacune des première et deuxième parois isolantes présente une portion en saillie de la face arrière de la couche semiconductrice et de la face arrière de la région en un matériau conducteur ou semiconducteur, et dans lequel une couche diélectrique de passivation revêt la face arrière de la couche semiconductrice et la face arrière de la région en un matériau conducteur ou semiconducteur, la couche diélectrique de passivation étant interrompue en vis-à-vis de la face arrière des portions en saillie des première et deuxième parois isolantes.

Selon un mode de réalisation, le capteur comporte en outre une couche antireflet revêtant la face arrière de la couche diélectrique de passivation et la face arrière des portions en saillie des première et deuxième parois isolantes.

Selon un mode de réalisation, le capteur comporte en outre une couche antireflet revêtant la face arrière de la couche diélectrique de passivation, la couche antireflet étant interrompue en vis-à-vis de la face arrière des portions en saillie des première et deuxième parois isolantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique et partielle d'un exemple de capteur d'images à éclairement par la face arrière ;
la figure 2 est une vue en coupe schématique et partielle d'un autre exemple de capteur d'images à éclairement par la face arrière ;
la figure 3 illustre une étape d'un procédé de fabrication d'un capteur d'images à éclairement par la face arrière selon un mode de réalisation ;
la figure 4 illustre une autre étape d'un procédé de fabrication d'un capteur d'images à éclairement par la face arrière selon un mode de réalisation ;
la figure 5 illustre une autre étape d'un procédé de fabrication d'un capteur d'images à éclairement par la face arrière selon un mode de réalisation ;
la figure 6 illustre une autre étape d'un procédé de fabrication d'un capteur d'images à éclairement par la face arrière selon un mode de réalisation ;
la figure 7 illustre une autre étape d'un procédé de fabrication d'un capteur d'images à éclairement par la face arrière selon un mode de réalisation ;
la figure 8 illustre une autre étape d'un procédé de fabrication d'un capteur d'images à éclairement par la face arrière selon un mode de réalisation ;
la figure 9 illustre une autre étape d'un procédé de fabrication d'un capteur d'images à éclairement par la face arrière selon un mode de réalisation ;
la figure 10 illustre une autre étape d'un procédé de fabrication d'un capteur d'images à éclairement par la face arrière selon un mode de réalisation ;
la figure 11 illustre une variante de mise en oeuvre du procédé des figures 3 à 10 ;
la figure 12 illustre une autre variante de mise en oeuvre du procédé des figures 3 à 10 ; et
la figure 13 est une vue en coupe schématique et partielle illustrant un autre exemple d'un capteur d'images à éclairement par la face arrière selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des zones de photodétection et des transistors de contrôle des pixels des capteurs décrits n'a pas été détaillée, les modes de réalisation décrits étant compatibles avec les structures usuelles de pixels de capteurs à éclairement par la face arrière.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

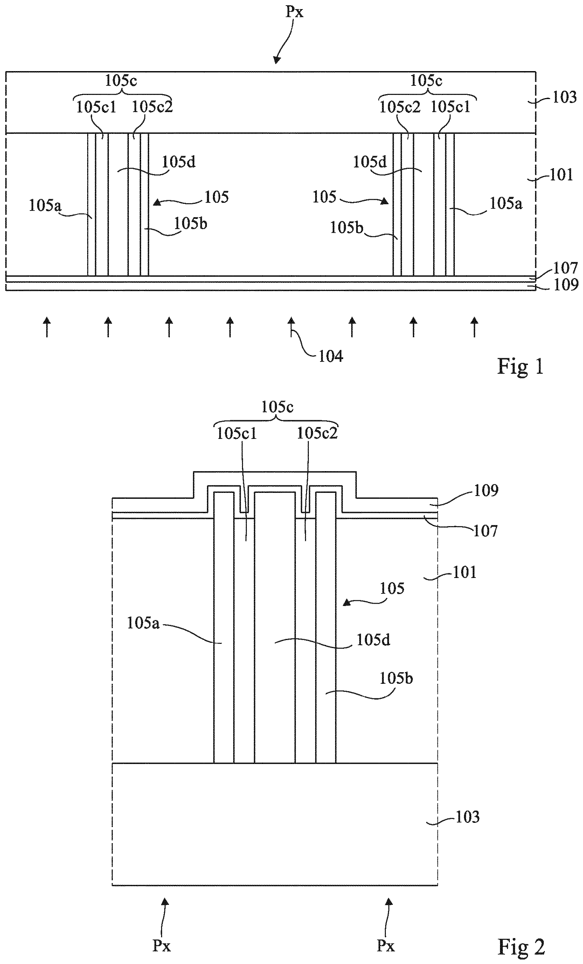

La figure 1 est une vue en coupe schématique et partielle d'un exemple de capteur d'images à éclairement par la face arrière. Le capteur de la figure 1 comprend une couche semiconductrice 101, par exemple en silicium monocristallin. Le capteur de la figure 1 comprend en outre une structure d'interconnexion 103 revêtant la face supérieure ou face avant de la couche semiconductrice 101. Le capteur de la figure 1 comprend une pluralité de pixels Px formés dans et sur la couche semiconductrice 101. Chaque pixel Px comprend au moins une zone photosensible (non détaillée) formée dans la couche semiconductrice 101, et un ou plusieurs transistors de contrôle (non détaillés) formés dans et sur la couche conductrice 101. Les pixels 101 sont connectés entre eux par des pistes conductrices (non détaillées) formées dans la structure d'interconnexion 103. En fonctionnement, le capteur est éclairé par sa face inférieure ou face arrière, c'est-à-dire par sa face opposée à la structure d'interconnexion 103, comme illustré par les flèches 104 de la figure 1.

On s'intéresse ici plus particulièrement à des capteurs du type illustré en figure 1, comprenant des murs d'isolation capacitifs 105 s'étendant verticalement à travers la couche semiconductrice 101, depuis la face avant et jusqu'à la face arrière de la couche 101. A titre d'exemple, dans chaque pixel, la zone photosensible du pixel est entièrement entourée, en vue de dessus, par un mur d'isolation capacitif 105 de forme annulaire. Chaque mur d'isolation capacitif 105 comprend deux parois verticales isolantes 105a et 105b, séparées par une région verticale conductrice ou semiconductrice 105c, par exemple en silicium polycristallin ou en silicium amorphe. Les régions 105a, 105b et 105c s'étendent par exemple chacune sur toute l'épaisseur de la couche semiconductrice 101, depuis la face avant jusqu'à la face arrière de la couche 101. Chacune des parois isolantes 105a et 105b a une face latérale extérieure en contact avec la couche semiconductrice 101 et une face latérale intérieure en contact avec la région 105c. A titre d'exemple, les parois isolantes 105a et 105b sont en oxyde de silicium. Dans l'exemple représenté, chaque mur d'isolation capacitif 105 comprend en outre une paroi isolante centrale 105d, par exemple en oxyde de silicium, s'étendant sur toute la hauteur du mur et séparant la région conductrice ou semiconductrice 105c en deux parois disjointes 105c1 et 105c2.

A titre d'exemple, l'épaisseur de la couche semiconductrice 101, et donc la hauteur des murs 105, est comprise entre 1 et 20 µm, par exemple entre 2 et 10 µm. Les régions conductrices ou semiconductrices 105c1 et 105c2 ont par exemple chacune une largeur comprise entre 10 et 100 nm, par exemple de l'ordre de 50 nm. La région isolante centrale 105d a par exemple une largeur comprise entre 10 et 200 nm, par exemple de l'ordre de 50 nm. Les régions isolantes externes 105a et 105b ont par exemple chacune une largeur comprise entre 5 et 40 nm, par exemple de l'ordre de 15 nm.

Dans chaque mur d'isolation capacitif 105, la paroi conductrice ou semiconductrice 105c1 et/ou 105c2 du mur peut être connectée électriquement, par sa face avant, à une borne d'application d'un potentiel de polarisation (non détaillée sur la figure) formée dans la structure d'interconnexion 103, ce qui permet de polariser la capacité formée entre la couche semiconductrice 101 et la paroi 105c1 et/ou la capacité formée entre la couche semiconductrice 101 et la paroi 105c2 pendant le fonctionnement du capteur.

Du côté de la face arrière du capteur, il est prévu une couche de passivation 107 en un matériau diélectrique, s'étendant de façon continue sur sensiblement toute la surface arrière du capteur, c'est-à-dire sur la face arrière de la couche semiconductrice 101 et sur la face arrière des murs d'isolation capacitifs 105. La couche 107 est par exemple en un matériau différent du matériau des parois isolantes 105a et 105b. A titre d'exemple, la couche 107 est en un matériau à forte constante diélectrique, c'est-à-dire de constante diélectrique supérieure à celle de l'oxyde de silicium, par exemple de l'oxyde d'hafnium (HfO₂) ou de l'oxyde d'aluminium (Al₂O₃) .

Dans l'exemple de la figure 1, le capteur comprend en outre une couche antireflet 109, par exemple en oxyde de tantale (Ta₂O₅), revêtant la face arrière de la couche de passivation 107.

En fonction des besoins de l'application, d'autres couches, non représentées, peuvent être prévues du côté de la face arrière du capteur, par exemple une couche de protection en oxyde de silicium, une couche de filtrage en résine colorée, une couche de microlentilles, etc.

Pour réaliser le capteur de la figure 1, on peut partir d'un substrat de départ relativement épais, par exemple en silicium, dont la partie supérieure est formée par la couche semiconductrice 101 du capteur.

Les pixels Px, les murs d'isolation capacitifs 105, et la structure d'interconnexion 103 sont alors formés dans et sur la couche semiconductrice 101, à partir de la face supérieure de substrat.

Une poignée de support est ensuite fixée sur la face supérieure de la structure d'interconnexion 103, puis le substrat est aminci par sa face inférieure ou face arrière, par exemple par meulage et/ou par amincissement chimique, éventuellement suivi d'une étape de planarisation ou polissage mécano-chimique (CMP), jusqu'à atteindre la face arrière de la couche semiconductrice 101 et des murs d'isolation capacitifs 105.

La couche de passivation 107, ainsi que les éventuelles couches supplémentaires de face arrière du capteur (la couche antireflet 109 dans l'exemple de la figure 1) sont ensuite déposées sur la face arrière de la couche semiconductrice 101 et des murs d'isolation capacitifs 105.

La poignée de support fixée à la face avant de la structure d'interconnexion 103 peut ensuite être retirée. A titre de variante, la poignée de support peut être conservée comme support mécanique jusqu'à la fin du procédé (et éventuellement dans le produit final). A titre de variante, la poignée de support peut comprendre un circuit intégré comprenant des transistors de contrôle des pixels du capteur.

En pratique, on constate que la capacité formée entre la paroi conductrice ou semiconductrice 105c1 et la couche semiconductrice 101 (séparées par la paroi isolante 105a), et la capacité formée entre la paroi conductrice ou semiconductrice 105c2 et la couche semiconductrice 101 (séparées par la paroi isolante 105b) présentent des tenues en tension relativement faibles. A titre d'exemple, lorsque l'épaisseur des parois isolantes 105a et 105b est choisie pour obtenir une tenue en tension théorique de 20 V entre la région 105c1 et la région 101 et entre la région 105c2 et la région 101, on observe, en pratique, que la tenue en tension réelle des capacités est d'environ 10 V. Au-delà de cette tension, des claquages sont susceptibles de se produire au voisinage de la face inférieure des parois 105a et 105b.

Pour résoudre ce problème, on peut prévoir, après l'étape d'amincissement du substrat 101 par sa face arrière, et avant l'étape de dépôt de la couche diélectrique de passivation 107, une étape de gravure partielle, par la face arrière, de la couche semiconductrice 101 et des régions conductrices ou semiconductrices 105c1 et 105c2, sélectivement par rapport aux régions isolantes 105a, 105b et 105d.

A l'issue de cette étape de gravure, les régions isolantes 105a, 105b et 105d des murs 105 présentent des portions en saillie de la face arrière de la couche semiconductrice 101 et de la face arrière des régions conductrices ou semiconductrices 105c1 et 105c2.

La couche de passivation 107 est ensuite déposée sur la face arrière de la couche semiconductrice 101 et sur la face arrière des régions conductrices ou semiconductrices 105c1 et 105c2, ainsi que sur la face arrière et sur les flancs des portions en saillie des régions isolantes 105a, 105b et 105d.

Les éventuelles couches supplémentaires de face arrière du capteur peuvent ensuite être déposées sur la face arrière de la couche 107.

La figure 2 est une vue en coupe schématique et partielle illustrant un exemple d'un capteur d'images à éclairement par la face arrière obtenu par ce procédé. La figure 2 représente un agrandissement d'une partie du capteur, centrée sur un mur d'isolation capacitif vertical 105 du capteur. Sur la figure 2, l'orientation du capteur est inversée par rapport à la figure 1. Autrement dit, sur la figure 2, la face arrière (ou face d'éclairement) du capteur correspond à sa face supérieure, et la face avant du capteur correspond à sa face inférieure.

Un avantage du procédé de fabrication décrit en relation avec la figure 2 et du capteur obtenu par ce procédé est une amélioration significative de la tenue en tension des murs d'isolation capacitifs 105. Cette amélioration s'explique notamment par l'augmentation du chemin électrique entre la couche semiconductrice 101 et la région conductrice ou semiconductrice 105c1 ou 105c2, via l'interface entre la paroi isolante 105a ou 105b et la couche de passivation 107.

A titre d'exemple, à dimensions identiques, et notamment pour une même épaisseur des parois isolantes 105a et 105b des murs 105, on observe une amélioration d'un facteur deux de la tenue en tension des capacités formées entre la région 105c1 et la couche 101 d'une part, et entre la région 105c2 et la couche 101 d'autre part.

Il serait toutefois souhaitable d'améliorer encore au moins en partie certains aspects des capteurs d'images à éclairement par la face arrière du type décrit en relation avec la figure 2.

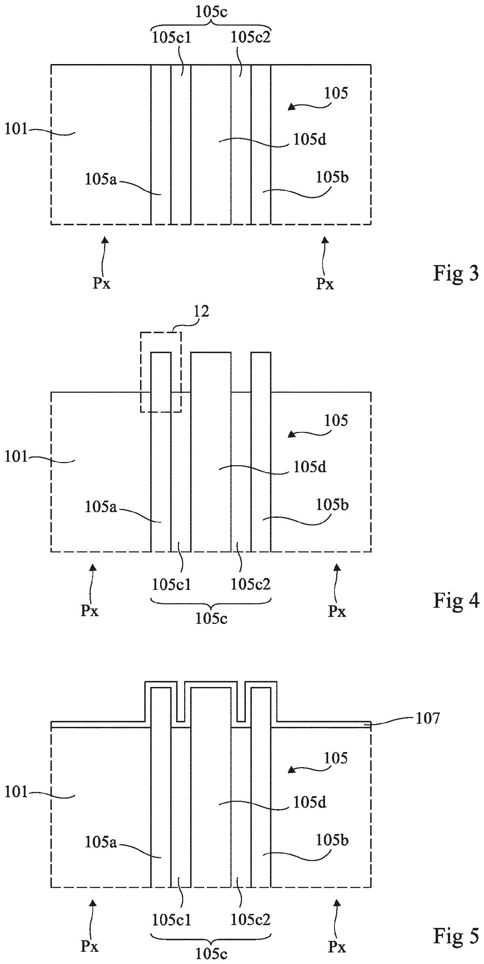

Les figures 3, 4, 5, 6, 7, 8, 9 et 10 sont des vues en coupe schématiques et partielles illustrant des étapes successives d'un exemple d'un procédé de fabrication d'un capteur d'images à éclairement par la face arrière selon un mode de réalisation.

Le capteur des figures 3 à 10 présente des éléments communs avec les capteurs des figures 1 et 2. Ces éléments ne seront pas détaillés à nouveau ci-après. Dans la suite, seules les différences avec les capteurs des figures 1 et 2 seront mises en exergue. On notera que les vues en coupe des figures 3 à 10 ont la même orientation que la vue en coupe de la figure 2 et représentent un agrandissement d'une partie supérieure du capteur, centrée sur un mur d'isolation capacitif vertical 105 du capteur.

La figure 3 illustre une étape initiale de formation d'une structure comportant la couche semiconductrice 101, et des murs d'isolation capacitifs 105 s'étendant verticalement de la face avant (face inférieure dans l'orientation des figures 3 à 10, non visible sur les figures 3 à 10) à la face arrière (face supérieure dans l'orientation des figures 3 à 10) de la couche semiconductrice 101. Pour réaliser cette structure, on peut, comme dans les exemples décrits précédemment, partir d'un substrat de départ relativement épais, par exemple en silicium, dont la partie avant est formée par la couche semiconductrice 101. Les pixels Px, les murs d'isolation capacitifs 105, et la structure d'interconnexion 103 (non visible sur les figures 3 à 10) sont alors formés dans et sur la couche semiconductrice 101, à partir de la face avant de substrat. Une poignée de support (non représentée) est ensuite fixée sur la face avant de la structure d'interconnexion 103 (c'est-à-dire la face de la structure d'interconnexion 103 opposée au substrat), puis le substrat est aminci par sa face arrière, par exemple par meulage, jusqu'à atteindre la face arrière de la couche semiconductrice 101 et des murs d'isolation capacitifs 105. L'étape d'amincissement du substrat peut notamment comprendre une étape de planarisation ou polissage mécano-chimique (CMP) visant à obtenir, après amincissement, une surface arrière sensiblement plane. Autrement dit, à l'issue de cette étape, les murs d'isolation capacitifs 105 du capteur affleurent au niveau de la face arrière de la couche semiconductrice 101 de façon à former une surface arrière sensiblement plane.

La figure 4 illustre une étape de retrait partiel ou renfoncement (recess) de la couche semiconductrice 101 et des régions conductrices ou semiconductrices 105c1 et 105c2, à partir de la face arrière de la structure obtenue à l'issue des étapes de la figure 3. Lors de cette étape, les régions isolantes 105a, 105b et 105d des murs d'isolation capacitifs 105 sont conservées. Pour cela, on réalise, à partir de la face arrière de la structure obtenue à l'issue des étapes de la figure 3, une gravure partielle de la couche semiconductrice 101 et des régions conductrices ou semiconductrices 105c1 et 105c2, sélective par rapport aux régions isolantes 105a, 105b et 105d. Par gravure sélective, on entend que la vitesse de gravure du ou des matériaux formant la couche 101 et les régions 105c1 et 105c2 (par exemple du silicium) est supérieure, par exemple au moins dix fois supérieure et de préférence au moins cent fois supérieure, à la vitesse de gravure du ou des matériaux formant les régions 105a, 105b et 105d (par exemple de l'oxyde de silicium). A titre d'exemple, la gravure mise en oeuvre à l'étape de la figure 4 est une gravure par plasma ou gravure sèche. A titre de variante une gravure humide peut être utilisée. L'épaisseur de la couche 101 et des régions 105c1 et 105c2 retirée à l'étape de la figure 4 est par exemple comprise entre 5 et 200 nm, et de préférence entre 10 et 50 nm. A titre d'exemple, la gravure mise en oeuvre à l'étape de la figure 4 est une gravure non localisée, c'est-à-dire que la couche semiconductrice 101 et les régions 105c1 et 105c2 sont amincies sur sensiblement toute la surface du capteur.

Ainsi, à l'issue de l'étape de la figure 4, du côté de la face arrière de la structure, les régions conductrices ou semiconductrices 105c1 et 105c2 des murs d'isolation capacitifs 105 s'interrompent sensiblement au même niveau que la face arrière de la couche semiconductrice 101. En revanche, les régions isolantes 105a, 105b et 105d des murs 105 présentent des portions en saillie de la face arrière de la couche semiconductrice 101 et de la face arrière des régions conductrices ou semiconductrices 105c1 et 105c2.

A l'issue de l'étape de gravure partielle sélective de la couche 101 et des régions 105c1 et 105c2, une étape de nettoyage chimique de la face arrière du capteur peut être prévue. Lors de cette étape, une mince couche d'oxyde (non représentée), d'oxyde natif ou d'oxyde chimique, d'épaisseur de l'ordre de 1 nm ou moins, peut se former sur la face arrière de la couche semiconductrice 101 et sur la face arrière des régions conductrices ou semiconductrices 105c1 et 105c2. A titre de variante, on peut prévoir une étape spécifique d'oxydation de la face arrière de la couche semiconductrice 101, en vue d'obtenir une couche d'oxyde un peu plus épaisse, par exemple d'épaisseur comprise entre 1 et 5 nm.

La figure 5 illustre une étape de dépôt de la couche de passivation 107 du capteur, sur et en contact avec la face arrière de la structure obtenue à l'issue des étapes des figures 3 et 4. La couche 107 est par exemple déposée par dépôt en couches monoatomiques successives (ALD). Plus généralement, toute autre méthode de dépôt conforme peut être utilisée, de façon que la couche 107 épouse le relief formé par les portions en saillie des parois isolantes 105a, 105b et 105d des murs 105. La couche de passivation 107 est par exemple déposée de façon continue sur toute la surface arrière du capteur. L'épaisseur de la couche de passivation 107 est par exemple inférieure à la hauteur des portions en saillie des parois isolantes 105a, 105b et 105d. A titre d'exemple, l'épaisseur de la couche de passivation 107 est comprise entre 2 et 100 nm, par exemple de l'ordre de 13 nm.

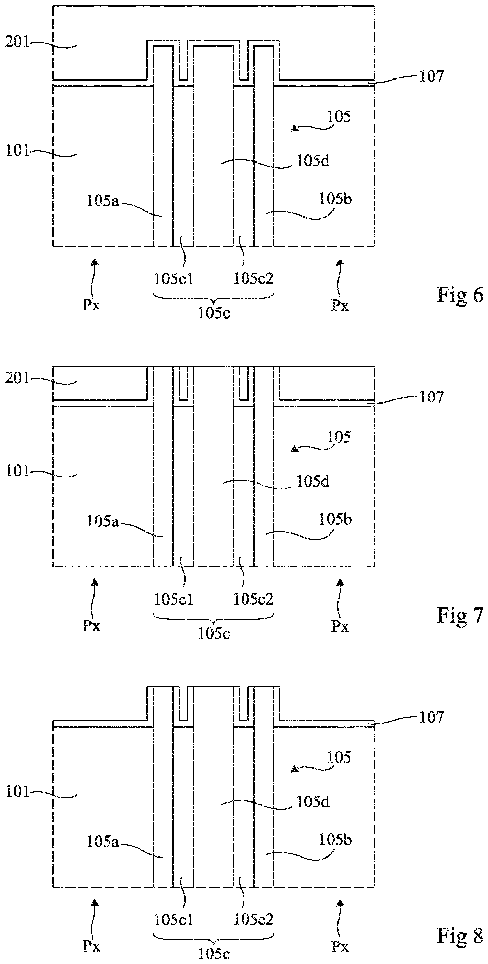

La figure 6 illustre une étape de dépôt d'une couche sacrificielle 201 sur la face supérieure de la structure obtenue à l'issue des étapes des figures 3, 4 et 5. La couche 201 est en un matériau gravable sélectivement par rapport au matériau de la couche 107 (par exemple de l'oxyde d'hafnium ou de l'oxyde d'aluminium) et par rapport au matériau des parois isolantes 105a, 105b et 105d (par exemple de l'oxyde de silicium). A titre d'exemple, la couche sacrificielle 201 est en nitrure de silicium, en résine ou en métal, par exemple un métal du groupe comprenant le cuivre, le tungstène et l'aluminium. A titre de variante, la couche sacrificielle 201 est en oxyde de silicium déposé à basse température de façon à présenter une densité inférieure à celle de l'oxyde de silicium des parois isolantes 105a, 105b et 105d et ainsi pouvoir être gravé sélectivement par rapport aux parois isolantes 105a, 105b et 105d. La couche sacrificielle 201 est par exemple déposée de façon continue sur toute la surface arrière du capteur. L'épaisseur de la couche sacrificielle 201 est par exemple choisie supérieure à la hauteur des portions en saillie des parois isolantes 105a, 105b et 105d. A titre d'exemple, l'épaisseur de la couche sacrificielle 201 est comprise entre 10 et 200 nm, par exemple de l'ordre de 50 nm.

La figure 7 illustre une étape d'amincissement, par la face arrière, de la structure obtenue à l'issue des étapes des figures 3, 4, 5 et 6, par exemple par planarisation ou polissage mécano-chimique (CMP), jusqu'à atteindre la face arrière des parois isolantes 105a, 105b et 105d. L'amincissement est interrompu lorsque la face arrière des portions en saillie des parois isolantes 105a, 105b et 105d est atteinte. Ainsi, à l'issue de cette étape, la couche de passivation 107 est interrompue en vis-à-vis de la face arrière des parois isolantes 105a, 105b et 105d. La couche de passivation 107 est en revanche conservée en vis-à-vis de la face arrière de la couche semiconductrice 101 et des régions conductrices ou semiconductrices 105c1 et 105c2, et sur les flancs des portions en saillie des parois isolantes 105a, 105b et 105d. A l'issue de cette étape, les faces arrières des parois isolantes 105a, 105b et 105d et des portions de couche 107 revêtant les flancs des parois isolantes 105a, 105b et 105d affleurent au niveau de la face arrière de la couche sacrificielle 201, de façon à former une surface arrière du capteur sensiblement plane.

La figure 8 illustre une étape de retrait des portions de la couche sacrificielle 201 subsistant en vis-à-vis de la face arrière de la couche semiconductrice 101 et des régions conductrices ou semiconductrices 105c1 et 105c2. Lors de cette étape, la couche sacrificielle 201 est retiré de façon sélective par rapport à la couche de passivation 107 et aux parois isolantes 105a, 105b et 105d. La couche sacrificielle 201 peut être retirée par gravure sèche ou par gravure humide.

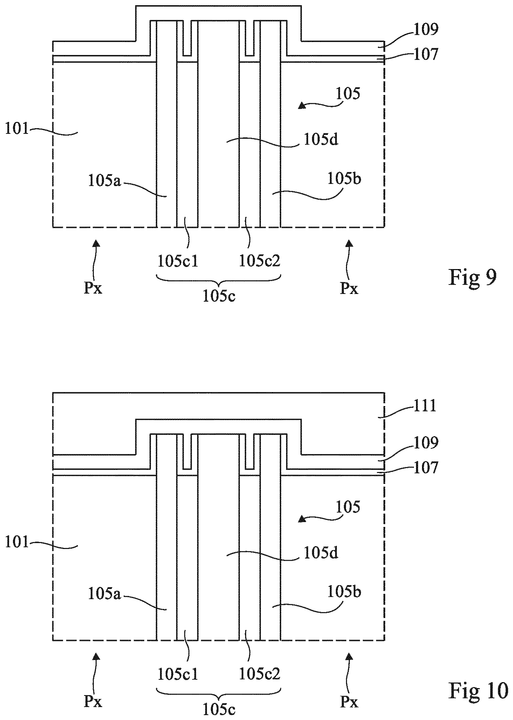

La figure 9 illustre une étape de dépôt de la couche antireflet 109, par exemple en oxyde de tantale, sur la face arrière de la structure obtenue à l'issue des étapes des figures 3, 4, 5, 6, 7 et 8. Plus particulièrement, dans cet exemple, la couche 109 est déposée sur et en contact avec la face arrière de la couche de passivation 107 en vis-à-vis de la couche semiconductrice 101 et des régions conductrices ou semiconductrices 105c1 et 105c2, et sur et en contact avec la face arrière des parois isolantes 105a, 105b et 105d. La couche antireflet 109 est par exemple déposée de façon continue sur toute la surface arrière du capteur. A titre d'exemple, la couche 109 est déposée par dépôt en couches monoatomiques successives (ALD). Plus généralement, toute autre méthode de dépôt conforme peut être utilisée. A titre d'exemple, l'épaisseur de la couche antireflet 109 est comprise entre 2 et 200 nm, par exemple de l'ordre de 47 nm.

La figure 10 illustre une étape de dépôt d'une couche isolante de protection 111, par exemple en oxyde de silicium, sur et en contact avec la face arrière de la couche antireflet 109. La couche de protection 111 est par exemple déposée de façon continue sur toute la surface arrière du capteur. A titre d'exemple, l'épaisseur de la couche de protection 111 est comprise entre 15 et 400 nm.

Comme indiqué précédemment, en fonction des besoins de l'application, d'autres couches, non représentées, peuvent être prévues du côté de la face arrière du capteur, par exemple une couche de filtrage en résine colorée, une couche de microlentilles, etc.

Un avantage du procédé de fabrication décrit en relation avec les figures 3 à 10 et du capteur obtenu par ce procédé est une diminution significative du courant d'obscurité détecté par les pixels du capteur.

Une explication possible de cet avantage est que la couche diélectrique de passivation 107 n'est pas parfaitement isolante électriquement, et peut, dans une structure du type décrit en relation avec la figure 2, conduire des charges électriques parasites des régions conductrices ou semiconductrices 105c1 et 105c2 vers les zones de photodétection des pixels formées dans la couche semiconductrice 101. Dans un capteur du type obtenu par le procédé des figures 3 à 10, l'interruption de la couche de passivation 107 en vis-à-vis de la face arrière des portions en saillie des parois isolantes 105a, 105b et 105d permet d'interrompre la conduction des charges parasites via la couche 107.

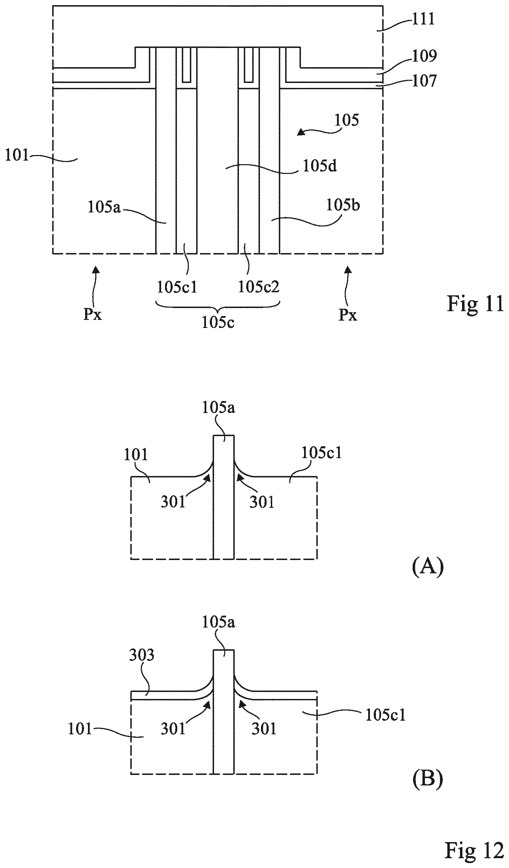

La figure 11 est une vue en coupe schématique et partielle illustrant une variante de mise en oeuvre du procédé des figures 3 à 10. La figure 11 est une vue dans le même plan de coupe que les figures 3 à 10, représentant le capteur obtenu à la fin du procédé.

Le procédé de la figure 11 diffère du procédé des figures 3 à 10 principalement en ce que, dans l'exemple de la figure 11, la couche antireflet 109 est déposée sur la face arrière de la couche de passivation 107 avant le dépôt de la couche sacrificielle 201 (non visible sur la figure 11). Ainsi, lors de l'étape de planarisation de la face arrière du capteur (figure 7) la couche de passivation 107 et la couche antireflet 109 sont toutes deux interrompues en vis-à-vis de la face arrière des parois isolantes 105a, 105b et 105d. Après retrait de la couche sacrificielle 201, la couche de protection 111 peut être déposée sur et en contact avec la face arrière de la couche antireflet 109 et sur et en contact avec la partie exposée de la couche de passivation 107 en vis-à-vis de la couche semiconductrice 101 et des régions conductrices ou semiconductrices 105c1 et 105c2, et sur et en contact avec la face arrière des parois isolantes 105a, 105b et 105d. Dans cette variante, le matériau de la couche sacrificielle 201 est choisi pour être gravable sélectivement non seulement par rapport au matériau de la couche 107 et par rapport au matériau des parois isolantes 105a, 105b et 105d, mais également par rapport au matériau de la couche 109.

Un avantage du procédé de fabrication de la figure 11 et du capteur obtenu par ce procédé est qu'il permet de réduire encore davantage le courant d'obscurité, en évitant la conduction de charges parasites des régions conductrices ou semiconductrices 105c1 et 105c2 vers la couche semiconductrice 101, via la couche 109.

La figure 12 illustre une autre variante du procédé des figures 3 à 10. La figure 12 comprend deux vues (A) et (B) représentant chacune un agrandissement d'une partie du capteur, au voisinage de la face arrière du capteur, au niveau d'une paroi isolante 105a d'un mur d'isolation capacitif vertical 105 du capteur (correspondant à la partie délimitée par un cadre 12 sur la figure 4).

La vue (A) de la figure 12 représente la face arrière du capteur à l'issue de l'étape de gravure partielle sélective de la couche 101 et des régions 105c1 et 105c2, décrite en relation avec la figure 4. Comme cela apparaît sur la figure 12(A), on observe qu'en pratique, la gravure de la couche 101 et des régions 105c1 et 105c2 n'est pas parfaitement uniforme. Plus particulièrement, suivant le type de procédé utilisé pour réaliser la gravure, il peut subsister des résidus du matériau de la couche 101 et des régions 105c1 et 105c2 au voisinage immédiat des parois isolantes 105a, 105b et 105d, par exemple en raison d'un effet d'ombrage, de sélectivité, etc. Ceci conduit à la formation, dans la couche 101 et/ou dans les régions 105c1 et 105c2, de structures 301 en pointe ou bec d'oiseau, prenant appui sur les parois isolantes 105a, 105b et 105c.

La vue (B) de la figure 12 illustre une étape d'oxydation de la face arrière de la structure obtenue à l'issue des étapes des figures 3 et 4, de façon à former une couche d'oxyde 303 relativement épaisse, par exemple comprise entre 1 et 10 nm, par exemple de l'ordre de 5 nm, sur la face arrière de la couche semiconductrice 101 et sur la face arrière des régions 105c1 et 105c2 des murs d'isolation capacitifs 105. Comme l'illustre la figure 12(B), cette étape d'oxydation conduit à arrondir significativement voire à supprimer les pointes des structures en bec d'oiseau 301 à l'interface avec les parois isolantes 105a, 105b et 105d. A titre d'exemple, l'étape d'oxydation est réalisée en soumettant la face arrière du capteur à un plasma à base d'oxygène, de préférence à une température inférieure à 400°C pour ne pas endommager la structure d'interconnexion 103 du capteur. A titre de variante, une oxydation chimique peut être prévue.

La suite du procédé est par exemple identique ou similaire à ce qui a été décrit précédemment en relation avec les figures 5 à 10.

Un avantage de la variante de réalisation de la figure 12 est qu'elle permet d'améliorer encore davantage la tenue en tension des murs d'isolation capacitifs du capteur.

Bien entendu, les variantes de réalisation des figures 11 et 12 peuvent être combinées.

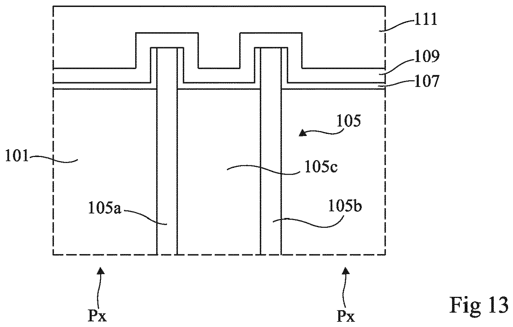

La figure 13 est une vue en coupe schématique et partielle illustrant un autre exemple d'un capteur d'images à éclairement par la face arrière selon un mode de réalisation.

La figure 13 est une vue dans le même plan de coupe que la figure 10. Le capteur de la figure 13 présente des éléments communs avec le capteur de la figure 10, et est réalisé par un procédé de fabrication similaire au procédé décrit en relation avec les figures 3 à 10. Dans la suite, seules les différences par rapport au capteur de la figure 10 seront détaillées.

Le capteur de la figure 13 diffère du capteur de la figure 10 principalement en ce que, dans l'exemple de la figure 13, les murs d'isolation capacitifs 105 ne comportent pas de paroi isolante centrale 105d. Ainsi, dans l'exemple de la figure 13, les régions 105c1 et 105c2 sont combinées en une seule région conductrice ou semiconductrice centrale 105c. Autrement dit, chaque mur d'isolation capacitif 105 comprend deux parois isolantes 105a et 105b dont les faces latérales extérieures sont en contact avec la couche semiconductrice 101, et une région conductrice ou semiconductrice 105c formant une paroi centrale unique dont les faces latérales sont en contact respectivement avec la face latérale intérieure de la paroi isolante 105a et avec la face latérale intérieure de la paroi isolante 105b.

Bien entendu, la variante de la figure 13 peut être combinée avec la variante de la figure 11 et/ou avec la variante de la figure 12.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, les modes de réalisation décrits ci-dessus ne se limitent pas aux exemples de dimensions numériques ni aux exemples de matériaux mentionnés dans la présente description.

## Revendications

1. Procédé de fabrication d'un capteur d'images, comportant les étapes successives suivantes :
a) réaliser une structure comportant une couche semiconductrice (101) ayant une face avant et une face arrière, et un mur d'isolation capacitif (105) s'étendant verticalement de la face avant à la face arrière de la couche semiconductrice, le mur d'isolation capacitif comprenant des première (105a) et deuxième (105b) parois isolantes séparées par une région (105c) en un matériau conducteur ou semiconducteur ;
b) graver, depuis la face arrière de ladite structure, une partie de l'épaisseur de la couche semiconductrice (101) et de la région (105c) en un matériau conducteur ou semiconducteur de façon sélective par rapport aux parois isolantes (105a, 105b), de façon que, à l'issue de la gravure, chacune des première (105a) et deuxième (105b) parois isolantes présente une portion en saillie de la face arrière de la couche semiconductrice (101) et de la face arrière de la région (105c) en un matériau conducteur ou semiconducteur ;
c) déposer une couche diélectrique de passivation (107) sur la face arrière de la structure ; et
d) retirer localement la couche diélectrique de passivation (107) en vis-à-vis de la face arrière des portions en saillie des première (105a) et deuxième (105b) parois isolantes.

2. Procédé selon la revendication 1, dans lequel l'étape d) comprend une étape de dépôt d'une couche sacrificielle (201) sur la face arrière de la couche diélectrique de passivation (107), suivie d'une étape d'amincissement de la couche sacrificielle (201) par sa face arrière jusqu'à atteindre la face arrière des portions en saillie des première (105a) et deuxième (105b) parois isolantes.

3. Procédé selon la revendication 2, dans lequel l'étape d) comprend en outre, après l'étape d'amincissement, une étape de retrait des portions restantes de la couche sacrificielle (201).

4. Procédé selon la revendication 2 ou 3, dans lequel la couche sacrificielle (201) est en nitrure de silicium.

5. Procédé selon l'une quelconque des revendications 1 à 4, comprenant en outre, après l'étape d), une étape de dépôt d'une couche antireflet (109) sur la face arrière de la couche diélectrique de passivation (107) et sur la face arrière des portions en saillie des première (105a) et deuxième (105b) parois isolantes.

6. Procédé selon l'une quelconque des revendications 1 à 4, comprenant, avant l'étape d), une étape de dépôt d'une couche antireflet (109) sur la face arrière de la couche diélectrique de passivation, et dans lequel, à l'étape d), la couche antireflet (109) est retirée localement en vis-à-vis de la face arrière des portions en saillie des première (105a) et deuxième (105b) parois isolantes.

7. Procédé selon la revendication 5 ou 6, dans lequel la couche antireflet (109) comprend de l'oxyde de tantale.

8. Procédé selon l'une quelconque des revendications 1 à 7, dans lequel la couche diélectrique de passivation (107) comprend un matériau diélectrique de constante diélectrique supérieure à celle de l'oxyde de silicium, par exemple de l'oxyde d'aluminium ou de l'oxyde d'hafnium.

9. Procédé selon l'une quelconque des revendications 1 à 8, comprenant, après l'étape b) et avant l'étape c), une étape d'oxydation de la face arrière de la couche semiconductrice (101) .

10. Procédé selon l'une quelconque des revendications 1 à 9, dans lequel la couche semiconductrice (101) est en silicium monocristallin, la région (105c) en un matériau conducteur ou semiconducteur est en silicium polycristallin ou amorphe, et les première (105a) et deuxième (105b) parois isolantes sont en oxyde de silicium.

11. Procédé selon l'une quelconque des revendications 1 à 10, dans lequel le mur d'isolation capacitif (105) comprend une troisième paroi isolante (105d) séparant la région (105c) en un matériau conducteur ou semiconducteur en deux parois (105c1, 105c2) distinctes.

12. Procédé selon l'une quelconque des revendications 1 à 11, dans lequel la structure réalisée à l'étape a) comprend en outre une structure d'interconnexion (103) revêtant la face avant de la couche semiconductrice (101).

13. Capteur d'images comportant une couche semiconductrice (101) ayant une face avant et une face arrière, et un mur d'isolation capacitif (105) s'étendant verticalement de la face avant à la face arrière de la couche semiconductrice, le mur d'isolation capacitif comprenant des première (105a) et deuxième (105b) parois isolantes séparées par une région (105c) en un matériau conducteur ou semiconducteur, dans lequel chacune des première (105a) et deuxième (105b) parois isolantes présente une portion en saillie de la face arrière de la couche semiconductrice (101) et de la face arrière de la région (105c) en un matériau conducteur ou semiconducteur, et dans lequel une couche diélectrique de passivation (107) revêt la face arrière de la couche semiconductrice (101) et la face arrière de la région (105c) en un matériau conducteur ou semiconducteur, la couche diélectrique de passivation (107) étant interrompue en vis-à-vis de la face arrière des portions en saillie des première (105a) et deuxième (105b) parois isolantes.

14. Capteur selon la revendication 13, comportant en outre une couche antireflet (109) revêtant la face arrière de la couche diélectrique de passivation (107) et la face arrière des portions en saillie des première (105a) et deuxième (105b) parois isolantes.

15. Capteur selon la revendication 13, comportant en outre une couche antireflet (109) revêtant la face arrière de la couche diélectrique de passivation (107), la couche antireflet (109) étant interrompue en vis-à-vis de la face arrière des portions en saillie des première (105a) et deuxième (105b) parois isolantes.

## Patentansprüche

1. Verfahren zur Herstellung eines Bildsensors, das die folgenden aufeinanderfolgenden Schritte aufweist:
a) Ausbilden einer Struktur aufweisend eine Halbleiterschicht (101) mit einer Vorderseite und einer Rückseite und eine kapazitive Isolationswand (105), die sich vertikal von der Vorderseite zur Rückseite der Halbleiterschicht erstreckt, wobei die kapazitive Isolationswand eine erste (105a) und eine zweite (105b) isolierende Wände aufweist, die durch einen Bereich (105c) aus einem Leiter- oder Halbleitermaterial getrennt sind;
b) Ätzen, von der Rückseite der Struktur, eines Teils der Dicke der Halbleiterschicht (101) und des Bereichs (105c) aus einem Leiter- oder Halbleitermaterial selektiv gegenüber den isolierenden Wänden (105a, 105b), so dass am Ende des Ätzens jeder der ersten (105a) und zweiten (105b) isolierenden Wände einen überstehenden Teil an der Rückseite der Halbleiterschicht (101) und der Rückseite des Bereichs (105c) aus einem Leiter- oder Halbleitermaterial aufweist;
c) Abscheiden einer dielektrischen Passivierungsschicht (107) an der Rückseite der Struktur; und
d) lokales Entfernen der dielektrischen Passivierungsschicht (107) gegenüber der Rückseite der vorstehenden Abschnitte der ersten (105a) und zweiten (105b) isolierenden Wände.

2. Verfahren nach Anspruch 1, wobei Schritt d) einen Schritt des Abscheidens einer Opferschicht (201) an der Rückseite der dielektrischen Passivierungsschicht (107) aufweist, gefolgt von einem Schritt des Ausdünnens der Opferschicht (201) von ihrer Rückseite her, um die Rückseite der vorstehenden Abschnitte der ersten (105a) und zweiten (105b) isolierenden Wände zu erreichen.

3. Verfahren nach Anspruch 2, wobei Schritt d) nach dem Ausdünnungsschritt ferner einen Schritt des Entfernens der verbleibenden Abschnitte der Opferschicht (201) aufweist.

4. Verfahren nach Anspruch 2 oder 3, wobei die Opferschicht (201) aus Siliziumnitrid hergestellt ist.

5. Verfahren nach einem der Ansprüche 1 bis 4, das ferner nach Schritt d) einen Schritt des Abscheidens einer Antireflexionsschicht (109) an der Rückseite der dielektrischen Passivierungsschicht (107) und auf der Rückseite der vorstehenden Abschnitte der ersten (105a) und zweiten (105b) isolierenden Wände aufweist.

6. Verfahren nach einem der Ansprüche 1 bis 4, das vor Schritt d) einen Schritt des Abscheidens einer Antireflexionsschicht (109) an der Rückseite der dielektrischen Passivierungsschicht aufweist, und wobei in Schritt d) die Antireflexionsschicht (109) gegenüber der Rückseite der vorstehenden Abschnitte der ersten (105a) und zweiten (105b) isolierenden Wände lokal entfernt wird.

7. Verfahren nach Anspruch 5 oder 6, wobei die Antireflexionsschicht (109) Tantaloxid aufweist.

8. Verfahren nach einem der Ansprüche 1 bis 7, wobei die dielektrische Passivierungsschicht (107) ein dielektrisches Material mit einer Dielektrizitätskonstante aufweist, die größer ist als die von Siliziumoxid, z.B. Aluminiumoxid oder Hafniumoxid.

9. Verfahren nach einem der Ansprüche 1 bis 8, das nach Schritt b) und vor Schritt c) einen Schritt des Oxidierens der Rückseite der Halbleiterschicht (101) aufweist.

10. Verfahren nach einem der Ansprüche 1 bis 9, wobei die Halbleiterschicht (101) aus einkristallinem Silizium besteht, der Bereich (105c) aus einem Leiter- oder Halbleitermaterial aus Polysilizium oder amorphem Silizium besteht und die ersten (105a) und zweiten (105b) isolierenden Wände Wand aus Siliziumoxid bestehen.

11. Verfahren nach einem der Ansprüche 1 bis 10, wobei die kapazitive Isolationswand (105) eine dritte Isolationswand (105d) aufweist, die den Bereich (105c) aus Leiter- oder Halbleitermaterial in zwei unterschiedliche Wände (105c1, 105c2) trennt.

12. Verfahren nach einem der Ansprüche 1 bis 11, wobei die in Schritt a) gebildete Struktur ferner eine Zwischenverbindungsstruktur (103) aufweist, die die Vorderseite der Halbleiterschicht (101) bedeckt.

13. Bildsensor aufweisend eine Halbleiterschicht (101), die eine Vorderseite und eine Rückseite aufweist, und eine kapazitive Isolationswand (105), die sich vertikal von der Vorderseite zur Rückseite der Halbleiterschicht erstreckt, wobei die kapazitive Isolationswand erste (105a) und zweite (105b) isolierende Wände aufweist, die durch einen Bereich (105c) aus einem Leiter- oder Halbleitermaterial getrennt sind, wobei jede der ersten (105a) und zweiten (105b) isolierenden Wände einen vorstehenden Abschnitt von der Rückseite der Halbleiterschicht (101) und von der Rückseite des Bereichs (105c) aus einem Leiter- oder Halbleitermaterial aufweist und wobei eine dielektrische Passivierungsschicht (107) die Rückseite der Halbleiterschicht (101) und die Rückseite des Bereichs (105c) aus einem Leiter- oder Halbleitermaterial bedeckt, wobei die dielektrische Passivierungsschicht (107) gegenüber der Rückseite der vorstehenden Abschnitte der ersten (105a) und zweiten (105b) isolierenden Wände unterbrochen ist.

14. Sensor nach Anspruch 13, der ferner eine Antireflexionsschicht (109) aufweist, die die Rückseite der dielektrischen Passivierungsschicht (107) und die Rückseite der vorstehenden Abschnitte der ersten (105a) und zweiten (105b) isolierenden Wände bedeckt.

15. Sensor nach Anspruch 13, der ferner eine Antireflexionsschicht (109) aufweist, die die Rückseite der dielektrischen Passivierungsschicht (107) bedeckt, wobei die Antireflexionsschicht (109) gegenüber der Rückseite der vorstehenden Abschnitte der ersten (105a) und zweiten (105b) isolierenden Wände unterbrochen ist.

## Claims

1. A method of manufacturing an image sensor, comprising the successive steps of:
a) forming a structure comprising a semiconductor layer (101) having a front side and a back side, and a capacitive insulation wall (105) extending vertically from the front side to the back side of the semiconductor layer, the capacitive insulation wall including first (105a) and second (105b) insulating walls separated by a region (105c) made of a conductor or semiconductor material;
b) etching, from the back side of said structure, part of the thickness of the semiconductor layer (101) and of the region (105c) made of a conductor or semiconductor material selectively over the insulating walls (105a, 105b) so that, at the end of the etching, each of the first (105a) and second (105b) insulating walls has a protruding portion of the back side of the semiconductor layer (101) and from the back side of the region (105c) made of a conductor or semiconductor material;
c) depositing a dielectric passivation layer (107) on the back side of the structure; and
d) locally removing the dielectric passivation layer (107) opposite the back side of the protruding portions of the first (105a) and second (105b) insulating walls.

2. The method of claim 1, wherein step d) comprises a step of depositing a sacrificial layer (201) on the back side of the dielectric passivation layer (107), followed by a step of thinning the sacrificial layer (201) from its back side to reach the back side of the protruding portions of the first (105a) and second (105b) insulating walls.

3. The method of claim 2, wherein step d) further comprises, after the thinning step, a step of removing the remaining portions of the sacrificial layer (201).

4. The method of claim 2 or 3, wherein the sacrificial layer (201) is made of silicon nitride.

5. The method of any of claims 1 to 4, further comprising, after step d), a step of depositing an antireflection layer (109) on the back side of the dielectric passivation layer (107) and on the back side of the protruding portions of the first (105a) and second (105b) insulating walls.

6. The method of any of claims 1 to 4, comprising, before step d), a step of depositing an antireflection layer (109) on the back side of the dielectric passivation layer and wherein, at step d), the antireflection layer (109) is locally removed opposite the back side of the protruding portions of the first (105a) and second (105b) insulating walls.

7. The method of claim 5 or 6, wherein the antireflection layer (109) comprises tantalum oxide.

8. The method of any of claims 1 to 7, wherein the dielectric passivation layer (107) comprises a dielectric material having a dielectric constant greater than that of silicon oxide, for example, aluminum oxide or hafnium oxide.

9. The method of any of claim 1 to 8, comprising, after step b) and before step c), a step of oxidizing the back side of the semiconductor layer (101).

10. The method of any of claims 1 to 9, wherein the semiconductor layer (101) is made of single-crystal silicon, the region (105c) made of a conductor or semiconductor material is made of polysilicon or amorphous silicon, and the first (105a) and second (105b) insulating walls are made of silicon oxide.

11. The method of any of claims 1 to 10, wherein the capacitive insulation wall (105) comprises a third insulating wall (105d) separating the region (105c) made of conductor or semiconductor material into two distinct walls (105cl, 105c2).

12. The method of any of claims 1 to 11, wherein the structure formed at step a) further comprises an interconnection structure (103) coating the front side of the semiconductor layer (101).

13. An image sensor comprising a semiconductor layer (101) having a front side and a back side, and a capacitive insulation wall (105) vertically extending from the front side to the back side of the semiconductor layer, the capacitive insulation wall comprising first (105a) and second (105b) insulating walls separated by a region (105c) made of a conductor or semiconductor material, wherein each of the first (105a) and second (105b) insulating walls has a protruding portion of the back side of the semiconductor layer (101) and from the back side of the region (105c) made of a conductor or semiconductor material, and wherein a dielectric passivation layer (107) coats the back side of the semiconductor layer (101) and the back side of the region (105c) made of a conductor or semiconductor material, the dielectric passivation layer (107) being interrupted opposite the back side of the protruding portions of the first (105a) and second (105b) insulating walls.

14. The sensor of claim 13, further comprising an antireflection layer (109) coating the back side of the dielectric passivation layer (107) and the back side of the protruding portions of the first (105a) and second (105b) insulating walls.

15. The sensor of claim 13, further comprising an antireflection layer (109) coating the back side of the dielectric passivation layer (107), the antireflection layer (109) being interrupted opposite the back side of the protruding portions of the first (105a) and second (105b) insulating walls.
